# EUROPÄISCHE PATENTSCHRIFT

(11) **EP 3 074 548 B1**
(45) Veröffentlichungstag und Bekanntmachung des Hinweises auf die Patenterteilung: **27.10.2021**
(21) Anmeldenummer: 14803051.3
(22) Anmeldetag: 26.11.2014
(51) Int. Cl.: C23C 14/06

(54) **MO-N BASIERTES HARTSTOFFSCHICHTSYSTEM**
MO-N BASED HARD LAYER SYSTEM
SYSTÈME DE COUCHE DURE À BASE DE MO-N

(30) Priorität: 29.11.2013 DE 102013018007
(43) Veröffentlichungstag der Anmeldung: 05.10.2016
(73) Patentinhaber: Oerlikon Surface Solutions AG, Pfäffikon, 8808 Pfäffikon (CH)
(72) Erfinder: SOBIEHCH, Matthias Lukas, 88142 Wasserburg (DE); FOPP-SPORI, Doris, 7302 Landquart (CH)
(74) Vertreter: Misselhorn, Hein-Martin
(86) Internationale Anmeldenummer: PCT/EP2014/003151
(87) Internationale Veröffentlichungsnummer: WO 2015/078581

(56) Entgegenhaltungen:
- GILEWICZ A ET AL: "The properties of molybdenum nitride coatings obtained by cathodic arc evaporation", SURFACE AND COATINGS TECHNOLOGY, Bd. 236, 12. September 2013 (2013-09-12), Seiten 149-158, XP028788586, ISSN: 0257-8972, DOI: 10.1016/J.SURFCOAT.2013.09.005
- KAZMANLI M K ET AL: "Effect of nitrogen pressure, bias voltage and substrate temperature on the phase structure of Mo-N coatings produced by cathodic arc PVD", INSPEC, THE INSTITUTION OF ELECTRICAL ENGINEERS, STEVENAGE, GB, 1 April 2003 (2003-04-01), XP002742142, DOI: 10.1016/S0257-8972(02)00866-6

## Beschreibung

Festkörper im tribologischen Kontakt können massivem Verschleiss unterliegen. Beispiele hierfür sind Komponenten im Getriebe oder Motor. Um die Komponenten vor Verschleiss zu schützen, wird der Kontakt meist geschmiert. Schmiermittel können Flüssig- oder Festkörper sein. Vor allem bei der Flüssigschmierung kann es zu Mangelschmierung kommen (z. B. bei Start- und Stoppverhalten reisst der Schmierfilm an der Grenzfläche zwischen den Komponenten ab) und die Komponenten reiben direkt aufeinander. Dieser Umstand kann den Verschleiss massiv erhöhen. Eine heutzutage gängige Lösung ist die Applikation von tribologisch aktiven Hartstoffschichten wie zum Beispiel DLC, WC/C oder CrN, welche den Schutz der Komponenten übernehmen und gleichzeitig den Reibwert gering halten. Da aber die Einsatztemperatur der erwähnten Komponenten immer höher wird, kommen vor allem die Kohlenstoff-basierten Schichten an ihre Leistungsgrenzen, insbesondere bei komplexen mechanischen und thermischen Belastungsprofilen.

### Stand der Technik

Kohlenstoff-basierte Hartstoffschichten sind Stand der Technik für tribologische Applikationen, insbesondere für Komponenten in der Automobilindustrie, für Werkzeuge zur Metallbearbeitung (Umformen und Zerspanung) und für Bauteile im allgemeinen Maschinenbau. So berichten z. B. die Patentdokumente US5707748 (metall-dotierte, Kohlenstoff-basierte Schichten) und US7067191 (WC/C, CrC/C) über Kohlenstoff-basierte, reibungsreduzierende Funktionsschichten für Werkzeuge und Komponenten unter Mangelschmierung sowie für den ungeschmierten Zustand. Trotz der vielen Vorteile dieser Schichten sind folgende Nachteile zu berücksichtigen:
1. Relativ aufwändige und teure Beschichtungsprozesse basierend auf Kathodenzerstäubung und CVD, inklusive aufwändiger Wartung der Beschichtungsanlagen infolge der ausgeprägten Hydrophilie der Kohlenstoff-basierten Schichten.
2. Teilweise ungenügende chemische Beständigkeit gegenüber bestimmten Additiven in modernen Schmiermitteln.
3. Verlust der strukturellen und chemischen Stabilität bei erhöhten Temperaturen (T > 300 °C).
4. Geringe Oxidationsbeständigkeit bei erhöhten Temperaturen (T > 300 °C).

Vor den oben dargestellten Nachteilen ist es ersichtlich, dass Kohlenstoff-basierte Hartstoffschichten bei erhöhten mechanischen und thermischen Belastungen an ihre Leistungsgrenzen gebracht werden.

Der Aufsatz "The properties of molybdenum nitride coatings obtained by cathodic arc evaporation",SURFACE AND COATINGS TECHNOLOGY, Bd. 236, 12. September 2013 (2013-09-12), Seiten 149-158, XP028788586,ISSN: 0257-8972, von GILEWICZ A ET AL offenbart eine γ-Mo2- N Hartstoffschicht auf einer Chromschicht. Von Mo-N basierten Schichten ist bekannt, dass sie sehr günstige tribologische Eigenschaften aufweisen. Es wird von selbstschmierenden Eigenschaften unter der Bildung von Molybdänoxid schon bei Raumtemperatur im tribologischen Kontakt berichtet. Auf der Basis von kinetischen Oxidationsstudien wird weiterhin berichtet, dass die Oxidation von Mo-N zu volatilem MoO3 bei 350 °C beginnt, und dass bis zu 550 °C ein Gleichgewicht zwischen Verdampfungs- und Oxidationsrate von MoO3 besteht. Erst oberhalb von 550 °C kommt es zu einer beschleunigten Verdampfung des gebildeten Molybdänoxids. Weitere Studien haben gezeigt, dass durch Kontrolle des PVD-Prozesses unterschiedliche Mo-N-Phasen abgeschieden werden können. Ausserdem wurde der Schichtverschleiss in Abhängigkeit der PVD-Prozessparameter untersucht, jedoch konnte kein signifikanter Zusammenhang gefunden werden. Ein Zusammenhang zwischen dem PVD-Prozess, der daraus resultierenden Mikrostruktur und der tribologischen Performance wurde somit bisher nicht aufgezeigt. Dieser Sachverhalt ist jetzt Gegenstand der vorliegenden Erfindung.

### Beschreibung der Erfindung

Die vorliegende Erfindung basiert auf der Erkenntnis, dass der Gegenkörperverschleiss (metallischer oder keramischer Natur) durch gezielte Einstellung der Schichtmikrostruktur gesteuert werden kann, ohne dass die chemischen und mechanischen Schichteigenschaften nachteilig verändert werden. Das bedeutet: Die kontrollierte Steuerung des PVD Schichtabscheidungsprozesses (Gasdruck und Bias-Spannung) ermöglicht die mikrostrukturellen Schichteigenschaften wie Phasenzusammensetzung, kristallographische Textur und die Kornmorphologie gezielt einzustellen, was wiederum im tribologischen Kontakt direkten Einfluss auf den Gegenkörperverschleiss hat.

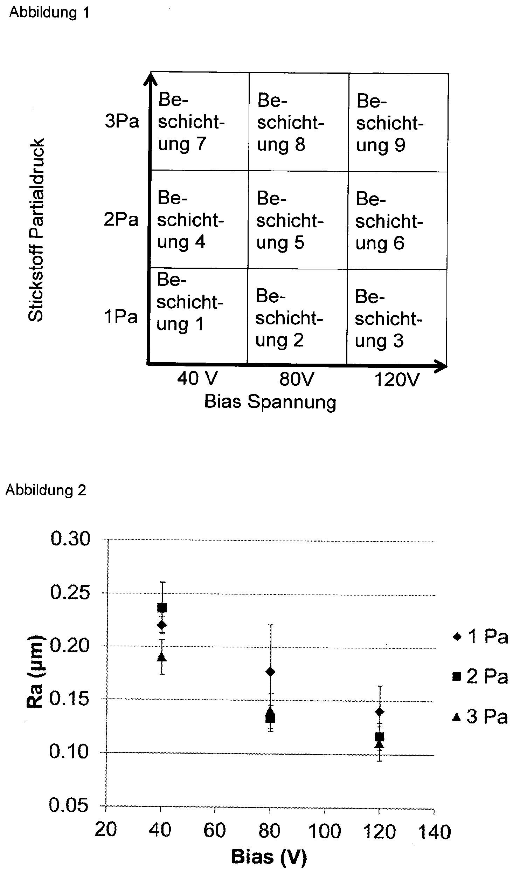

Die Mo-N Hartstoffschichten wurden in einer industriellen Anlage (INNOVA) von Oerlikon Balzers mittels reaktiver Funkenverdampfung in reiner Stickstoffatmosphäre bei Temperaturen von ca. 450°C abgeschieden. Alle Mo-N Hartstoffschichten (Beschichtung 1-9) hatten eine mehr oder weniger konstante Schichtdicke von etwa 4 µm. Lediglich die Prozessparameter Stickstoff-Partialdruck (1 bis 3 Pa) und Bias-Spannung (-40 bis -120 V) wurden variiert, siehe Abb.1.

Auf dieser Weise sind die Molybdännitrid-Schichten durch die Reaktion vom Molybdän (aus dem Funkenverdampfen von Molybdäntargets) mit Stickstoff (aus dem in die Beschichtungskammer eingelassenen Stickstoffgasfluss) gebildet worden.

Im Folgenden werden die Ergebnisse zusammenfassend dargestellt:

Es zeigen:
Abb. 1: Prozessparameter Stickstoff-Partialdruck und Bias-Spannung
Abb. 2: Zusammenhang zwischen Oberflächenrauigkeit und Bias-Spannung.
Abb. 3: Änderung der Schichtmikrostruktur (Kornmorphologie und kristallographische Textur) in Abhängigkeit vom Stickstoff-Partialdruck.
Abb. 4: Zusammenhang zwischen Stickstoff-Partialdruck und Gegenkörperverschleiss für zwei unterschiedliche tribologische Tests gegen Stahl (100Cr6) bei RT .

Unabhängig von den Prozessparameter Stickstoff-Partialdruck und Bias-Spannung wurde bei allen hergestellten Mo-N Hartstoffschichten eine Schichthärte von ca. 32 GPa, ein biaxialer E-Modul von ca. 355 GPa und eine relativ glatte Oberfläche mit wenigen Droplets (siehe Abb. 2) festgestellt. Auch der Reibwert, ermittelt aus dem Standard Pin on Disk Test ist mit ca. 0.6 gegen Stahl (100Cr6) und mit ca. 0.4 für Keramik (Al2O3) erwies sich als im Wesentlichen konstant. Die chemische Zusammensetzung gemessen mit EDX bei 15 kV ergab für alle Schichten ganz grob betrachtet 50 at.% Mo und 50 at.% N, wobei zu beobachten war, dass mit zunehmendem Stickstoff-Partialdruck der Mo-Gehalt abnahm. Die Oberflächenrauhigkeit konnte unabhängig vom Stickstoff-Partialdruck mit zunehmender Bias-Spannung reduziert werden, siehe Abb. 2.

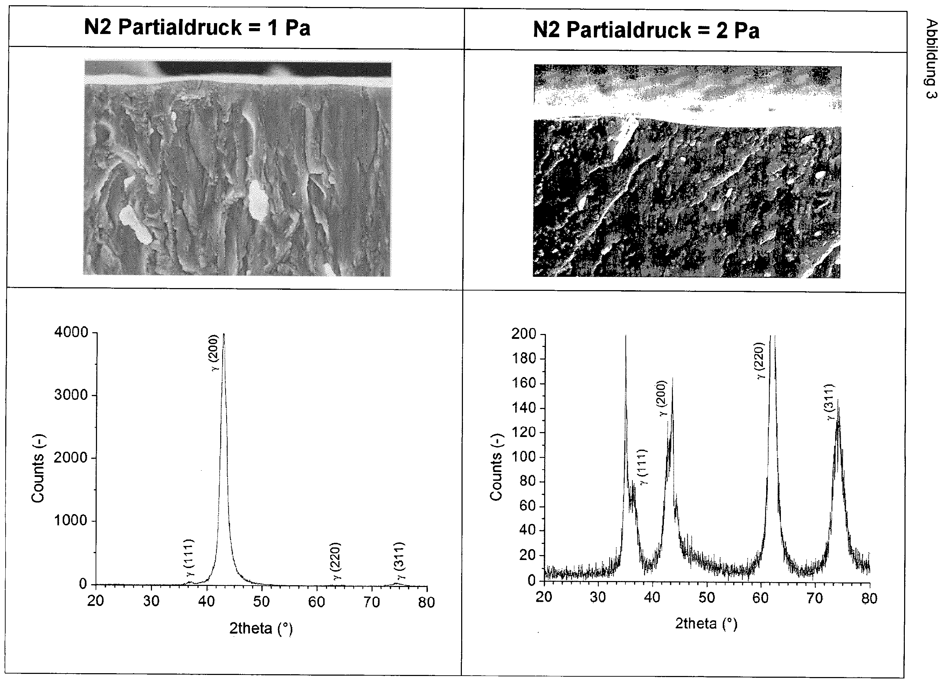

Es wurde festgestellt dass der Prozessparameter "Stickstoff-Partialdruck" direkten Einfluss auf die mikrostrukturellen Schichteigenschaften hat. Es konnte folgender Zusammenhang erkannt werden: Mo-N Hartstoffschichten abgeschieden bei einem Stickstoff-Partialdruck von 1 Pa weisen unabhängig von der Bias-Spannung eine "grob-körnige" Kornmorphologie im Bruch-Querschnitt und eine ausgeprägte kristallographische Textur auf (Intensitätsverhältnis der beiden Peaks 200/111 von grösser 10 bis unendlich, besonders bevorzugt im Bereich 20 bis 400) und sind zudem einphasig (kubisches γ-Mo2N). Die "grob-körnige" Kornmorphologie kann mittels Messung der XRD-FWHM (Halbwertsbreite des 200 Peaks) absolut (d.h. gegen die Referenzprobe Korund Al2O3 NIST Standard SRM 1976a) mit 0.34° - 0.94°, besonders bevorzugt mit 0.44° - 0.84° angegeben werden. Mo-N Hartstoffschichten abgeschieden bei einem Stickstoff-Partialdruck ab 2 Pa bis 3 Pa weisen unabhängig von der Bias-Spannung eine "fein-körnige" Kornmorphologie im Bruch-Querschnitt und nahezu keine kristallographische Textur auf (Intensitätsverhältnis der beiden Peaks 200/111 von kleiner 10, besonders bevorzugt kleiner 2.3) und sind vermutlich zweiphasig (kubisches γ-Mo2N und hexagonales Die "fein-körnige" Kornmorphologie kann mittels Messung der XRD-FWHM (Halbwertsbreite des 200 Peaks) absolut mit 0.94°-1.24°, besonders bevorzugt mit 1.09° -1.19° angegeben werden. Das bedeutet zusammengefasst, dass die Schichtmikrostruktur gezielt über den Prozessparameter Stickstoff-Partialdruck eingestellt werden kann. In Abb. 3 ist dieser Zusammenhang exemplarisch für einen Stickstoff-Partialdruck von 1 und 2 Pa dargestellt.

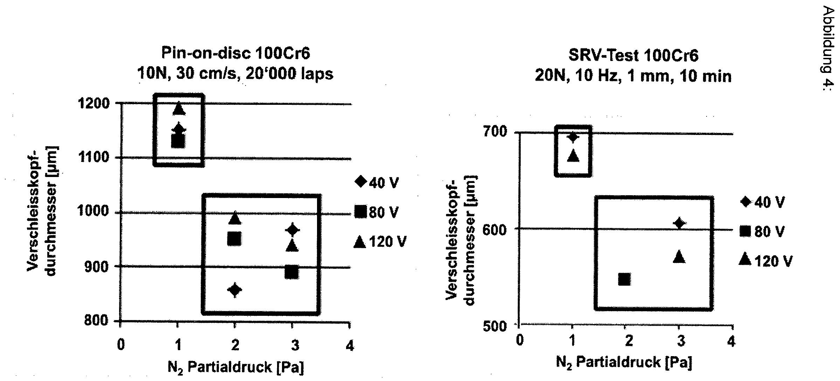

Des Weiteren konnte ein direkter Zusammenhang zwischen Schichtmikrostruktur und Tribologie, insbesondere in Bezug auf Gegenkörperverschleiss (Metall und Keramik) unter trockenen Bedingungen bei RT, festgestellt werden: Mo-N Hartstoffschichten abgeschieden bei einem Stickstoff-Partialdruck von 1 Pa weisen unabhängig von der Bias-Spannung einen deutlich höheren Gegenkörperverschleiss auf im Vergleich zu Mo-N Hartstoffschichten abgeschieden bei einem Stickstoff-Partialdruck von 2 und 3 Pa. Dieser Zusammenhang konnte für zwei unterschiedlichen tribologische Tests (Standard Pin on Disk und Schwingungs-Reibverschliess Test) gezeigt werden, siehe Abb. 4.

Für die durchgeführten Tests mit einer relativ kurzen Testdauer von ca. 1 Stunde ist eine Performancesteigerung von ca. 20% ersichtlich. Es ist davon auszugehen, dass mit zunehmender Testdauer eine zunehmende Performancesteigerung resultiert.

Die vorliegende Erfindung bezieht sich zudem auf ein Verfahren zur Verbesserung des Gegenkörperverschleisses im tribologischen Kontakt zu Stahl und Keramik dadurch gekennzeichnet, dass mittels PVD Schichtabscheidung zumindest ein Molybdännitrid-umfassendes Hartstoffschichtsystem auf die Oberfläche eines Körpers aufgebracht wird, wobei das Hartstoffschichtsystem zumindest eine Hartstoffschicht aus Molybdännitrid umfasst, wobei das Hartstoffschichtsystem aus einer im Wesentlichen aus Mo-N bestehenden äußersten Hartstoffschicht und zumindest einer zweiten im Wesentlichen aus Mo-N bestehenden Hartstoffschicht besteht, wobei das Hartstoffschichtsystem optional zumindest eine Haftschicht oder Stützschicht oder andere Art von Schicht aus einem anderen, nicht-Mo-N basierten Material umfasst, dadurch gekennzeichnet, dass die Molybdännitrid-Hartstoffschicht die kubische Phase des Molybdännitrids γ-Mo₂N umfasst, welche ein Intensitätsverhältnis der beiden zugehörigen Peaks 200/111 von kleiner 10, vorzugsweise kleiner 2.3 hat und eine absolute Halbwertsbreite am 200 Peak von 0.94° - 1.24°, vorzugsweise von 1.09°-1.19°, aufweist.

Die vorliegende Erfindung betrifft auch Verfahren zur Verbesserung des Gegenkörperverschleisses im tribologischen Kontakt zu Stahl und Keramik, wobei zumindest ein Mo-N basiertes Hartstoffschichtsystem mittels PVD Schichtabscheidung auf die Oberfläche eines Körpers aufgebracht wird, und wobei vor der Beschichtung auf diese Körperoberfläche PVD Testschichtabscheidungen bei unterschiedlichen Stickstoff-Partialdrücken durchgeführt werden und derartig beschichtete Testoberflächen auf die mechanischen, strukturellen und/oder chemischen sowie tribologischen Eigenschaften entsprechend dem jeweils vorliegenden tribologischen Kontakt untersucht werden wobei das Untersuchungsergebnis für die PVD Schichtabscheidung auf die Oberfläche des Körpers herangezogen wird.

Die vorliegende Erfindung betrifft ebenfalls Mo-N basierte Hartstoffschichtsysteme mit einer Mikrostruktur, welche nahezu keine kristallographische Textur hat, und ein Intensitätsverhältnis der beiden Peaks 200/111 (hinsichtlich der kubischen Phase γ-Mo₂N des Molybdännitrids) aufweist, welches kleiner 10, besonders bevorzugt kleiner 2.3 ist und auch eine absolute Halbwertsbreite am 200 Peak von 0.94° - 1.24°, besonders von 1.09° - 1.19°, aufweist.

### Konkret betrifft die vorliegende Erfindung:

Hartstoffschichtsystem zur Verbesserung des Gegenkörperverschleisses im tribologischen Kontakt zu Stahl bzw. Keramik, wobei das Hartstoffschichtsystem Mo-N basierte Hartstoffschichten umfasst, wobei das Hartstoffschichtsystem aus einer im Wesentlichen aus Mo-N bestehenden äußersten Hartstoffschicht und zumindest einer zweiten im Wesentlichen aus Mo-N bestehenden Hartstoffschicht besteht, wobei das Hartstoffschichtsystem optional zumindest eine Haftschicht oder Stützschicht oder andere Art von Schicht aus einem anderen nicht Mo-N basierten Material umfasst, wobei die äußerste Hartstoffschicht ein Intensitätsverhältnis der beiden Peaks 200/111 der kubischen Phase des Molybdännitrids γ-Mo 2 N aufweist, welches kleiner 10° ist, und am 200 Peak der kubischen Phase des Molybdännitrids γ-Mo 2 N eine absolute Halbwertsbreite von 0.94° - 1.24° aufweist und die zweite Hartstoffschicht ein Intensitätsverhältnis der beiden Peaks 200/111 der kubischen Phase des γ-Mo 2 N von größer 10 aufweist.

Vorzugsweise ist das Intensitätsverhältnis der beiden Peaks 200/111 2.3, und/oder vorzugsweise beträgt die absolute Halbwertsbreite am 200 Peak 1.09° bis 1.19°.

Vorzugsweise umfasst die Mo-N basierte Hartstoffschicht zumindest noch eine weitere Phase des Molybdännitrids, welche vorzugsweise die hexagonale Phase δ-MoN sein kann.

Bei gewissen Anwendungen wurde es gefunden, dass es vorteilhaft sein kann, wenn das Hartstoffschichtsystem lediglich eine oder mehrere Mo-N basierte Hartstoffschichten umfasst. Jedoch kann das Hartstoffschichtsystem auch Schichten aus anderen Materialien umfassen, welche zum Beispiel als Haftschichten oder Stutzschichten oder als andere Art von Schichten dienen können. Die vorliegende Erfindung betrifft ausserdem auch beschichtete oder zumindest teilweise beschichtete Körper, deren Beschichtung zumindest ein Hartstoffschichtsystem gemäss einer der oben beschriebenen Ausführungsformen umfasst.

Die Beschichtung eines Körpers mit einem Hartstoffschichtsystem gemäss einer der oben beschriebenen Ausführungsformen ist besonders vorteilhaft, wenn der Körper zur Anwendung unter tribologischem Kontakt bestimmt ist.

Zur Verbesserung des Gegenkörperverschleisses im tribologischen Kontakt zu Stahl und Keramik kann man, gemäss der vorliegenden Erfindung, zumindest einen Körper, welcher unter tribologischem Kontakt stehen wird, mit einem Hartstoffschichtsystem gemäss einem der vorangehenden Ausführungsformen mittels PVD Schichtabscheidung beschichten.

Zur Abscheidung eines Hartstoffschichtsystems gemäss einem der vorangehenden Ausführungsformen wird es bevorzugt ein Verfahren zu verwenden, bei dem zumindest eine Mo-N basierte Hartstoffschicht mittels Funkenverdampfen von Molybdäntargets in einem reaktiven, stickstoffhaltigen Atmosphäre auf der zu beschichtenden Substratoberfläche abgeschieden wird, wobei der Stickstoff-Partialdruck in der Beschichtungskammer konstant gehalten wird.

Gemäss den oben beschriebenen Untersuchungen könnte die Verwendung eines Stickstoff-Partialdrucks von zumindest 2 Pa oder von zumindest von 3 Pa von Vorteil sein.

Falls gewünscht kann man zumindest während der Abscheidung der Mo-N basierte -Hartstoffschicht eine Bias-Spannung am zu beschichtenden Substrat anlegen und durch Justierung der Bias-Spannung eine vorbestimmte Oberflächenrauhigkeit der Schicht erreichen.

Die vorliegende Erfindung betrifft Hartstoffschichtsysteme, welche neben der oben erwähnte Mo-N basierte Hartstoffschicht auch zumindest eine zweite Schicht umfassen, wobei die zweite Schicht vorzugsweise auch eine Mo-N basierte Hartstoffschicht ist, welche im Wesentlichen aus Molybdännitrid besteht und eine Kornmorphologie aufweist, die gröber ist als die Kornmorphologie der ersten Mo-N basierten Hartstoffschicht.

Die zweite Schicht mit der "grob-körnigen" Kornmorphologie weist ein Intensitätsverhältnis der beiden Peaks 200/111 (hinsichtlich der kubischen Phase γ-Mo₂N des Molybdännitrids) grösser 10 auf, oder noch bevorzugt mindestens grösser 2.3.

Ein solches Schichtsystem wird abgeschieden, in dem man für die Abscheidung der Schicht mit "grob-körniger" Kornmorphologie eine Stickstoff-Partialdruck kleiner 2 Pa und für die Abscheidung der Schicht mit "fein-körniger" Kornmorphologie einen Stickstoff-Partialdruck gleich oder grösser 2 Pa gemäss der vorliegenden Erfindung verwendet.

Erfindungsgemäß wird die Schicht mit "fein-körniger" Kornmorphologie als äusserste Schicht abgeschieden.

## Patentansprüche

1. Hartstoffschichtsystem zur Verbesserung des Gegenkörperverschleisses im tribologischen Kontakt zu Stahl bzw. Keramik, wobei das Hartstoffschichtsystem Mo-N basierte Hartstoffschichten umfasst¹, wobei das Hartstoffschichtsvstem aus einer im Wesentlichen aus Mo-N bestehenden äußersten Hartstoffschicht und zumindest einer zweiten im Wesentlichen aus Mo-N bestehenden Hartstoffschicht besteht, wobei das Hartstoffschichtsystem optional zumindest eine Haftschicht oder Stützschicht oder andere Art von Schicht aus einem anderen nicht Mo-N basierten Material umfasst, **dadurch gekennzeichnet, dass**
die äußerste Hartstoffschicht ein Intensitätsverhältnis der beiden Peaks 200/111 der kubischen Phase des Molybdännitrids γ-Mo₂N aufweist, welches kleiner 10 ist, und am 200 Peak der kubischen Phase des Molybdännitrids γ-Mo₂N eine absolute Halbwertsbreite von 0.94° - 1.24° aufweist
und die zweite Hartstoffschicht ein Intensitätsverhältnis der beiden Peaks 200/111 der kubischen Phase des γ-Mo₂N von grösser 10 aufweist.

2. Hartstoffschichtsystem nach Anspruch 1, **dadurch gekennzeichnet, dass** eine im Wesentlichen aus Mo-N bestehende Hartstoffschicht zumindest noch eine weitere Phase des Mo-N umfasst.

3. Hartstoffschichtsystem nach Anspruch 2, **dadurch gekennzeichnet dass** die zumindest eine weitere Phase hexagonales γ-MoN ist.

4. Hartstoffschichtsystem nach einem der Ansprüche 1 bis 3, **dadurch gekennzeichnet, dass** die im Wesentlichen aus Mo-N bestehende Hartstoffschicht, die unter der äußersten im Wesentlichen aus Mo-N bestehenden Hartstoffschicht abgeschieden ist, eine Kornmorphologie aufweist, die gröber ist als die Kornmorphologie der äußersten im Wesentlichen aus Mo-N bestehenden Hartstoffschicht.

5. Verfahren zur Abscheidung eines Hartstoffschichtsystems mittels Funkenverdampfen von Molybdäntargets in einer reaktiven, stickstoffhaltigen Atmosphäre auf der zu beschichtenden Oberfläche gemäss einem der vorangehenden Ansprüche 1 bis 4 auf einer zu beschichtenden Substratoberfläche, **dadurch gekennzeichnet, dass**
- die Beschichtungstemperatur während des Beschichtungsvorganges etwa 450°C beträgt,
- und zumindest eine im Wesentlichen aus MoN bestehende Hartstoffschicht mit einem Intensitätsverhältnis der beiden Peaks 200/111 der kubischen Phase des γ-Mο₂N von grösser 10 abgeschieden wird,
- wobei der Stickstoff-Partialdruck in der Beschichtungskammer konstant kleiner als 2 Pa gehalten wird,
- und zumindest eine im Wesentlichen aus MoN bestehende Hartstoffschicht mit einem Intensitätsverhältnis der beiden Peaks 200/111 der kubischen Phase des γ-Mo₂N von kleiner 10 abgeschieden wird,
- wobei der Stickstoff-Partialdruck in der Beschichtungskammer konstant grösser als 2 Pa gehalten wird.

6. Methode zur Verbesserung des Gegenkörperverschleisses im tribologischen Kontakt zu Stahl und Keramik, **dadurch gekennzeichnet, dass** zumindest ein Körper, welcher unter tribologischem Kontakt stehen wird, mittels eines Verfahrens nach Anspruch 5 beschichtet wird.

## Claims

1. Hard material layer system to improve the counter body wear in tribological contact with steel or ceramics, wherein the hard material layer system comprises Mo-N based hard material layers, wherein the hard material layer system consists of an outermost hard material layer consisting essentially of Mo-N and at least a second hard material layer consisting essentially of Mo-N, wherein the hard material layer system optionally comprises at least one adhesive layer or supporting layer or other type of layer made of another, non-No_N based material,
**characterized in that**
the outermost hard material layer has an intensity ratio of the two peaks 200/111 of the cubic phase of the molybdenum nitride γ-Mo₂N, which is less than 10, and
the hard material layer system has an absolute half-width of 0.94° - 1.24° at peak 200 of the cubic phase of the molybdenum nitride γ-Mo₂N
and the second hard material layer has an intensity ratio of the two peaks 200/111 of the cubic phase of γ-Mo₂N of greater than 10.

2. Hard material layer system according to claim 1, **characterized in that** one hard material layer consisting essentially of Mo-N comprises at least one further phase of Mo-N.

3. Hard material layer system according to claim 2, **characterized in that** the at least one further phase is hexagonal y-MoN.

4. Hard material layer system according to one of claims 1 to 3, **characterized in that** the hard material layer which essentially consists of Mo-N and is deposited under the outermost hard material layer consisting essentially of Mo-N has a grain morphology that is coarser than the grain morphology of the outermost hard material layer consisting essentially of Mo-N.

5. Method for depositing a hard material layer system by means of spark evaporation of molybdenum targets in a reactive, nitrogen-containing atmosphere on the surface to be coated according to one of the preceding claims 1 to 4 on a substrate surface to be coated, **characterized in that**
- the coating temperature during the coating process is around 450° C,
- and at least one hard material layer consisting essentially of MoN is deposited with an intensity ratio of the two peaks 200/111 of the cubic phase of γ-Mo₂N of greater than 10,
- wherein the nitrogen partial pressure in the coating chamber is kept constant below 2 Pa,
- and at least one hard material layer consisting essentially of MoN is deposited with an intensity ratio of the two peaks 200/111 of the cubic phase of γ-Mo₂N of less than 10
- wherein the nitrogen partial pressure in the coating chamber is kept constant greater than 2.

6. Method to improve the counter body wear in tribological contact with steel or ceramics, **characterized in that** at least one body which will be in tribological contact is coated by means of a method according to claim 5.

## Revendications

1. Système de couches de matériau dur pour améliorer l'usure du corps antagoniste en contact tribologique avec l'acier ou la céramique, le système de couches de matériau dur comprenant des couches de matériau dur à base de Mo-N, le système de couches de matériau dur se composant d'une couche extérieure de matériau dur se composant essentiellement de Mo-N et du moins une seconde couche de matériau dur se composant essentiellement de Mo-N, le système de couches de matériau dur comprenant facultativement au moins une couche adhésive ou une couche de support ou d'autre type de couche faite d'un matériau non basé sur No_N
**caractérisé en ce que**
la couche extérieure de matériau dur a un rapport d'intensité des deux pics 200/111 de la phase cubique du nitrure de molybdène γ-Mo₂N, qui est inférieur à 10, et
la couche de matériau dur extérieure a une demi-largeur absolue de 0,94° - 1,24° au pic 200 de la phase cubique du nitrure de molybdène y-Mo₂N et la seconde couche de matériau dur a un rapport d'intensité des deux pics 200/111 de la phase cubique du γ-Mo₂N, qui est supérieur à 10.

2. Système de couches de matériau dur selon la revendication 1, **caractérisé en ce qu'**une couche de matériau dur se composant essentiellement de Mo-N comprend au moins une autre phase du Mo-N.

3. Système de couches de matériau dur selon la revendication 2, **caractérisé en ce que** la du moins une autre phase est y-MoN hexagonal.

4. Système de couches de matériau dur selon l'une des revendications 1 à 3, **caractérisé en ce que** la couche de matériau dur qui se compose essentiellement de Mo-N et qui est déposée sous la couche extérieure de matériau dur se composant essentiellement de Mo-N a une morphologie de grain qui est plus grossière que la morphologie de grain de la couche extérieure de matériau dur se composant essentiellement de Mo-N.

5. Procédé de dépôt d'un système de couches de matériau dur sur la surface à revêtir au moyen de l'évaporation par étincelle de cibles de molybdène dans une atmosphère réactive contenant de l'azote selon l'une des revendications précédentes 1 à 4 sur une surface de substrat à revêtir, **caractérisé en ce que**
- la température de revêtement pendant le procès de revêtement est d'environ 450°C,
- et du moins une couche de matériau dur se composant essentiellement de Mo-N est déposée d'un rapport d'intensité des deux pics 200/111 de la phase cubique du γ-Mo₂N, qui est supérieur à 10,
- la pression partielle d'azote dans la chambre de revêtement est maintenue constamment inférieure à 2 Pa,
- et du moins une couche de matériau dur se composant essentiellement de Mo-N est déposée d'un rapport d'intensité des deux pics 200/111 de la phase cubique du γ-Mo₂N, qui est inférieur à 10,
- la pression partielle d'azote dans la chambre de revêtement est maintenue constamment supérieure à 2 Pa.

6. Méthode pour améliorer l'usure du corps antagoniste en contact tribologique avec l'acier et la céramique, **caractérisé en ce que** du moins un corps qui sera en contact tribologique est revêtu au moyen d'un procédé selon la revendication 5.
